# EUROPÄISCHE PATENTSCHRIFT

(11) **EP 0 907 210 B1**
(45) Veröffentlichungstag und Bekanntmachung des Hinweises auf die Patenterteilung: **06.03.2002**
(21) Anmeldenummer: 98118313.0
(22) Anmeldetag: 28.09.1998
(51) Int. Cl.: H01L 31/048

(54) **Kontaktlose Photovoltaik-Energieauskopplung**
Contactless photovoltaic energy-extraction
Extraction d'énergie photovoltaique sans contact

(30) Priorität: 30.09.1997 DE 19743379
(43) Veröffentlichungstag der Anmeldung: 07.04.1999
(73) Patentinhaber: EUROPÄISCHE GEMEINSCHAFT (EG), L-2920 Luxembourg (LU)
(72) Erfinder: Sachau, Jürgen, Dr., 21020 Ispra (IT)
(74) Vertreter: Weinmiller, Jürgen

(56) Entgegenhaltungen:
- DE-A- 19 508 250
- DE-A- 19 718 046
- PATENT ABSTRACTS OF JAPAN vol. 1996, no. 06, 28. Juni 1996 (1996-06-28) & JP 08 032099 A (TERUMO CORP;OTHERS: 01), 2. Februar 1996 (1996-02-02)
- PATENT ABSTRACTS OF JAPAN vol. 1998, no. 02, 30. Januar 1998 (1998-01-30) & JP 09 275644 A (OMRON CORP), 21. Oktober 1997 (1997-10-21)
- HAAN DE S W H ET AL: "DEVELOPMENT OF A 100W RESONANT INVERTER FOR AC-MODULES" COMMISSION OF THE EUROPEAN COMMUNITIES. 12-TH EUROPEAN PHOTOVOLTAIC SOLAR ENERGY CONFERENCE. PROCEEDINGS OF THE INTERNATIONAL CONFERENCE, 11. - 15. April 1994, XP002033672

## Beschreibung

Die Erfindung betrifft eine Vorrichtung zur kontaktlosen Auskopplung von photovoltaisch erzeugter elektrischer Energie.

Es ist bekannt, daß die elektrische Energieaufbereitung für photovoltaische Energiewandler über Reihenschaltung, Parallelschaltung und Konvertierung mit Stromrichtern in unterschiedlicher Aufeinanderfolge zu erreichen ist. Aus der deutschen Patentanmeldung DE-A-195 08 250 ist eine Solaranlage bekannt, bei der jedem Solarmodul ein Wechselrichter räumlich zugeordnet ist, der die erzeugte Energie unmittelbar in Wechselstrom konvertiert, sodaß der Ausfall eines Moduls nur zu einer Verringerung der Gesamtleistung der Anlage führt, nicht zu einem Abfall der Nennspannung.

Ein Nachteil von bekannten Anlagen liegt darin, daß die gewonnene elektrische Energie aus den üblicherweise gekapselten Moduln durch elektrische Leiter herausgeführt werden muß, die durch die Kapselung hindurchgeführt sind. Diese Durchführungen bilden Schwachstellen in Hinblick auf die mechanische Stabilität und die Dichtigkeit.

Aufgabe der Erfindung ist daher, die in photovoltaischen Zellen erzeugte elektrische Energie in einer Weise auszukoppeln, die die Einkapselung der Zellen in keiner Weise einschränkt, d.h. keine mechanischen und elektrischen Durchführungen erfordert.

Diese Aufgabe wird erfindungsgemäß dadurch gelöst, daß elektrische Leiter innerhalb der Kapselung derart mit elektrischen Leitern außerhalb der Kapselung angeordnet werden, daß sie transformatorisch gekoppelt sind.

Weitere mögliche Ausgestaltungen sind durch die Ansprüche 2 und 3 gekennzeichnet.

In den bevorzugten Ausgestaltungen wird mindestens eine solche Vorrichtung am Rand der Photovoltaik-Module mit wicklungsförmigen Leitern innerhalb und außerhalb des PV-Moduls angeordnet. Bei Modulen ohne Rahmen können die Vorrichtungen frei angeordnet werden. Der elektrischen Verbindung der Vorrichtung mit den PV-Zellen innerhalb des Moduls kann ein Teil der Energieaufbereitung vorgeschaltet sein, während der verbleibende Teil außerhalb des Moduls angeordnet wird. Die Teile der Energieaufbereitung innerhalb und außerhalb der Kapselung können über weitere transformatische und optische Kopplungen beider Teile - auch zur Signalübertragung - zusammenwirken. Bei der weiteren Ausgestaltung kann die Energieaufbereitung oder Teile davon direkt in die mechanische Halterung des Moduls integriert oder daran befestigt werden. In der bevorzugten Ausführung für gerahmte Module wird die Energieaufbereitung in Rahmen eingebaut, die die Module umfassen. Diese Rahmen können auf einfache Weise, z.B. über Steckverbinder, in die elektrische Installation einbezogen werden.

Die wesentlichen Vorteile der Vorrichtung liegen darin, daß eine galvanische Trennung erzielt wird und keine elektrischen Verbindungen benötigt werden, die durch die Einkapselung der photovoltaischen Energiewandler hindurchgeführt werden müssen. Insofern lassen sich die PV-Module vollständig ohne Durchführungen einkapseln, Korrosions- und Alterungseinflüsse durch Umwelteinwirkungen ausschließen und Lebensdauer und Zuverlässigkeit deutlich erhöhen.

Die Vorrichtung kann für alle Arten von photovoltaischen Energiewandlern, Kapselungen und Energieaufbereitungen verwendet werden. Ein Ausführungsbeispiel ist in den beiden folgenden Zeichnungen dargestellt.

Es zeigen:

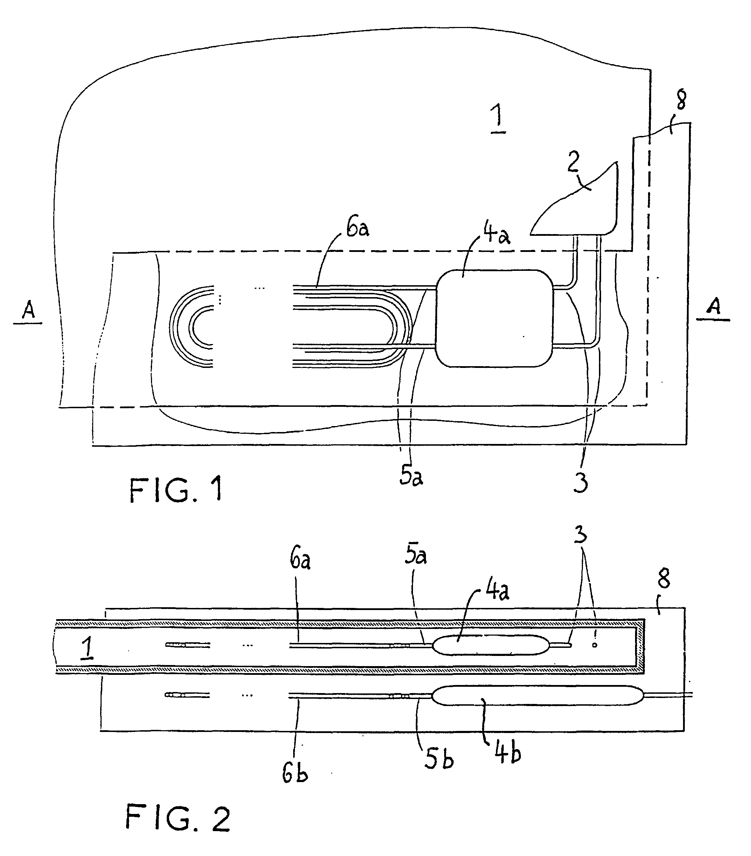

Fig. 1 die Teil-Aufsicht auf ein PV-Modul mit den darin liegenden Teilen einer Energieaufbereitung und einer Vorrichtung zur kontaktlosen Energieauskopplung. Innerhalb der Kapselung sind die in das PV-Modul (1) eingekapselten PV-Zellen (2) in ihren Reihen/Parallelschaltungen durch mindestens zwei Anschlußleiter (3) mit dem innerhalb des Moduls liegenden Teil einer Energieaufbereitung (4a) verbunden, die wiederum über elektrische Leiter (5a) innerhalb des Moduls eine Wicklung (6a) speist. Außerhalb der Modulkapselung befindet sich die mechanische Halterung des gekapselten Moduls, z.B. in Form eines Rahmens (8), der den Bereich der Zellen (2) freiläßt.
Figur 2 den Querschnitt A-A durch Modul und Rahmen. Innerhalb des Moduls (1) sind die Leiter (5a) und die Wicklung (6a) zu sehen, die mit einer außerhalb des Moduls liegenden ähnlichen Wicklung (6b) transformatorisch gekoppelt ist. Letztere besitzt eine Windungszahl, wie sie für den außerhalb des Moduls angeordneten Teil (4b) der Energieaufbereitung benötigt wird, der mit der Wicklung(6b)über Leiter(5b) verbunden ist und die photovoltaisch erzeugte und z.B. in Form von Gleich-, Wechsel- oder Drehstrom konvertierte elektrische Leistung weiterleitet.

## Patentansprüche

1. Vorrichtung zur kontaktlosen Auskopplung elektrischer Energie aus einem gekapselten photovoltaischen Modul, **dadurch gekennzeichnet, daß** innerhalb der Kapselung ein Mittel (4a) zur Energieaufbereitung, sowie eine von diesem Mittel gespeister elektrischen Leiter in wicklungsform (6a) vorgesehen sind, während außerhalb der Kapselung eine weitere Wicklung (6b) mit elektrischen Leitern so angeordnet ist, daß sich eine transformatorische Kopplung zwischen beiden Wicklungen ergibt.

2. Vorrichtung nach Anspruch 1, **dadurch gekennzeichnet, daß** die weitere Wicklung (6b) ein weiteres Mittel (4b) zur Energieaufbereitung speist, das die letztlich gewünschte Form der elektrischen Gleich-, Wechsel-, Drehstrom Energie liefert.

3. Vorrichtung nach einem der vorstehenden Ansprüche, **dadurch gekennzeichnet, daß** die außerhalb der Kapselung angeordnete weitere Wicklung (6b) in einen Rahmen (8) integriert ist, der zur Halterung mindestens eines gekapselten photovoltaischen Moduls dient.

## Claims

1. A device for a contactless extraction of electric energy from a sealed photovoltaic module, **characterized in that** an energy processing means (4a) and a coil-shaped electrical conductor (6a) connected to this means are disposed inside the sealing, whereas outside of said sealing a further coil-shaped electrical conductor (6b) is disposed in such a way that the two coils are coupled in a transformer-like fashion.

2. A device according to claim 1, **characterized in that** the further coil-shaped electrical conductor (6b) drives a further means (4b) which finally supplies the electric energy in the desires AC, DC or three-phase AC form.

3. A device according to any one of the preceding claims, **characterized in that** the further coil-shaped electrical conductor (6b) outside the sealing is integrated into a frame 8, which supports at least one sealed photovoltaic module.

## Revendications

1. Dispositif pour l'extraction de l'énergie électrique sans contact d'un module photovoltaïque encapsulé, **caractérisé en ce qu'**on prévoit à l'intérieur du module un moyen (4a) pour le traitement de l'énergie ainsi qu'un conducteur électrique en forme d'une bobine (6a) alimenté par ce moyen, alors qu'à l'extérieur de l'encapsulation on prévoit un autre conducteur électrique en forme de bobine (6b) de sorte qu'on obtient un couplage du type transformateur entre les deux bobines.

2. Dispositif selon la revendication 1, **caractérisé en ce que** l'autre conducteur en forme de bobine (6b) alimente un autre moyen pour le traitement de l'énergie qui fournit enfin l'énergie électrique sous la forme désirée, à savoir en continu, alternatif ou triphasé.

3. Dispositif selon l'une des revendications précédentes, **caractérisé en ce que** l'autre conducteur en forme de bobine (6b) à l'extérieur de l'encapsulation est intégré dans un cadre (8) qui sert de support pour au moins un module photovoltaïque encapsulé.
